# EUROPEAN PATENT APPLICATION

(11) **EP 1 816 660 A1**
(43) Date of publication of application: **08.08.2007**
(21) Application number: 05762208.6
(22) Date of filing: 30.06.2005
(51) Int. Cl.: H01F 38/34, G01R 15/00, G01R 15/06

(54) **AN ORGANIC COMBINED INSULATED DRY ELECTRONIC TRANSFORMER FOR OUTPUTTING THE OPTICAL SIGNALS**

(30) Priority: 01.11.2004 CN 200410086285
(71) Applicant: Wang, Ruzhang, Beijing 101400 (CN)
(72) Inventor: Wang, Ruzhang, Beijing 101400 (CN)
(74) Representative: Texier, Christian
(86) International application number: PCT/CN2005/000955
(87) International publication number: WO 2006/047922

(57) **Abstract**

An organic combined insulated dry electronic transformer for outputting an optical signal, in which an organic insulated capacitor voltage-divider insulator is used as the main insulator to bear all the whole high voltage. A coreless coil is wound around the outside of the tap of capacitance plate in the capacitor voltage-divider insulator to measure current; or a low voltage signal is taken from the capacitance plate adjacent to the tap of capacitance plate in the capacitor voltage-divider insulator to measure voltage; then the received current signal or the voltage signal is transformed into an optical signal by a converter that converts an electric signal into an optical signal and then outputted. The coreless coil as a current sensor has ground potential and the capacitor as a voltage sensor has low potential.

## Description

### FIELD OF THE INVENTION

The present invention relates to an organic combined insulated dry electronic transformer for outputting an optical signal, which is used for measurement of current and voltage, or start of relay protection device in a transformer substation.

### BACKGROUND OF THE INVENTION

Conventional mutual inductors may be sorted as follows: (1) electromagnetic oil-filled transformers and SF6 gas-filled transformers; (2) electromagnetic organic insulated dry transformers; (3) photoelectric transformers.

There have been over hundred years since the electromagnetic oil-filled transformers first appeared in the world. In this kind of transformers, there is an oil-paper insulation between a primary winding and a secondary winding, the outer insulation is a porcelain bushing shell, the secondary winding is an iron core coil, which drives an ammeter and a relay protection device via conducting wires according to current signal and voltage signal obtained by electromagnetic induction.

Later, the SF6 gas-filled transformer was invented, with SF6 gas having higher insulation strength replacing oil insulation, and other parts similar to the electromagnetic oil-filled transformer.

Both the two kinds of mutual inductors suffer from problems of leakage, environment pollution, big amount of maintenance, relatively high fault rate, big size, heavy, and the like, to different extents.

An organic insulated dry current transformer was proposed in China recently, such as in the utility model ZL99201400.X, titled "New Dry High-Voltage Current Transformer," issued on February 10, 1999 by the State Intellectual Property Office of China. Although still is an electromagnetic mutual inductor, the organic insulated dry current transformer has an organic insulation film as its insulating material and a capacitor voltage-divider structure as its insulation structure, and this kind of organic insulated dry current transformer is out of oil, out of porcelain, fire proof, explosion proof, pollution-flashover proof, compact, light, almost no maintenance needed, and has high safety and reliability. However, all the electromagnetic mutual inductors have the following problems: (1) each of the mutual inductor has to be provided with a plurality of secondary windings having different functions according to requirements of the user; and capacity of the iron core has to be made relatively large, sometimes a magnetic circuit has to be opened, so as to truly and rapidly respond to signals and prevent distortion and delay resulted from saturation of the iron core; (2) resistance of leads of the secondary circuit causes a large amount of electric energy consumption; (3) signal is easily influenced by electromagnetic interference, etc in transmission.

Recently, 500kV photoelectric mutual inductors produced by some foreign companies, such as ABB, have entered into China and been used in power network. Some Chinese companies are also striving to develop photoelectric mutual inductors, and have launched some products into trial operation. For a photoelectric mutual inductor, there are sensors, collectors, a signal processor, a D/A converter, and a photoelectric converter, as well as laser reception part, transformation part and power supply part for supplying power to the above devices disposed on the high voltage side. The converter converts a high voltage electric signal into an optical signal, and the optical signal is sent from the high voltage side to the low voltage side via an optical fiber and then converted into an electric signal by a photoelectric converter for driving an ammeter and a relay protection device. The precondition for the development and application of the photoelectric mutual inductor is that in recent years, the ammeters have been improved to electronic ones, and the relay protection devices have been improved to microprocessor-based ones, which need small power. However, the conventional photoelectric mutual inductors mentioned above still have the following problems: (1) electric circuits such as the sensors and the converter disposed on the high voltage side are not stable enough due to environment interference; (2) the power supply for supplying power to them is one of the difficulties in system design; in recent years, laser is generally utilized as power supply by transferring it to the high voltage side via an optical fiber, then converting it into electrical energy for supplying power to the electric circuits, however, there are still some technical difficulties, such as the current drive circuit and temperature control circuit of the semiconductor laser; (3) because it is the optical fiber that bears all the whole high voltage, though the optical fiber insulation is good, a supporting carrier with high insulation is still required; usually, the optical fiber is disposed within an oil-filled or gas-filled porcelain bushing shell, which consequentially results in the weakness due to an oil-filled or gas-filled insulation structure, and accordingly, the high voltage insulation components becomes a component of the photoelectric transformer that it is complex and easy to produce fault.

### SUMMARY OF THE INVENTION

The object of the present invention is to overcome the deficiency of the conventional photoelectric mutual inductor, providing an organic combined insulated dry electronic transformer for outputting an optical signal, wherein coreless coil, as a current sensor, has ground potential; a capacitor, as a voltage sensor, has low potential; and a converter for converting an electric signal into an optical pulse signal has ground potential.

An organic combined insulated dry electronic transformer for outputting an optical signal provided according to the present invention comprises: an electric conductor; a capacitor voltage-divider insulator consisting of organic insulation layers and cylindrical capacitance plates alternatively wound around the electric conductor, wherein each cylindrical capacitance plate is made of conductive or semi-conductive material, and the longer the radial distance from the capacitance plate to the electric conductor is, the shorter the axial length of the capacitance plate is; an organic insulated outer jacket tightly wrapped around the outer surface of the capacitor voltage-divider insulator; and wiring clips each disposed respectively at each end of the electric conductor; a grounded housing fitted over the outside of the organic insulated outer jacket and located within a section defined by the tap of capacitance plate; a coreless coil and a converter disposed inside the grounded housing, wherein the coreless coil is fitted over the capacitor voltage-divider insulator and the converter is used for converting an electric signal, after processed, into an optical signal; electric signal input terminals and corresponding optical signal output terminals disposed on the converter, wherein the electric signal input terminals on the converter are respectively connected to leads at both ends of the coreless coil, and silicon rubber umbrellas disposed on the outer jacket of the capacitor voltage-divider insulator at the surface of its two ends beyond the grounded housing.

Another organic combined insulated dry electronic transformer for outputting an optical signal provided according to the present invention comprises: an electric conductor; a capacitor voltage-divider insulator consisting of organic insulation layers and cylindrical capacitance plates alternatively wound around the electric conductor, wherein each cylindrical capacitance plate is made of conductive or semi-conductive material, and the longer the radial distances from the organic insulation layer and the capacitance plate to the electric conductor are, the shorter the axial lengths of the organic insulation layer and the capacitance plate are; an organic insulated outer jacket tightly wrapped around the outer surface of the capacitor voltage-divider insulator; and wiring clips each disposed respectively at each end of the electric conductor; a grounded housing fitted over the outside of the organic insulated outer jacket and located within a section defined by the tap of capacitance plate; a converter disposed inside the grounded housing for converting an electric signal into an optical signal; electric signal input terminals and corresponding optical signal output terminals are disposed on the converter; a measurement lead led out from the capacitance plate adjacent to the tap of capacitance plate; a tap lead led out from the tap of capacitance plate, wherein the measurement lead and the tap lead are respectively connected to the electric signal input terminals of the converter, and silicon rubber umbrellas disposed on the outer jacket of the capacitor voltage-divider insulator at the surface of its two ends beyond the grounded housing.

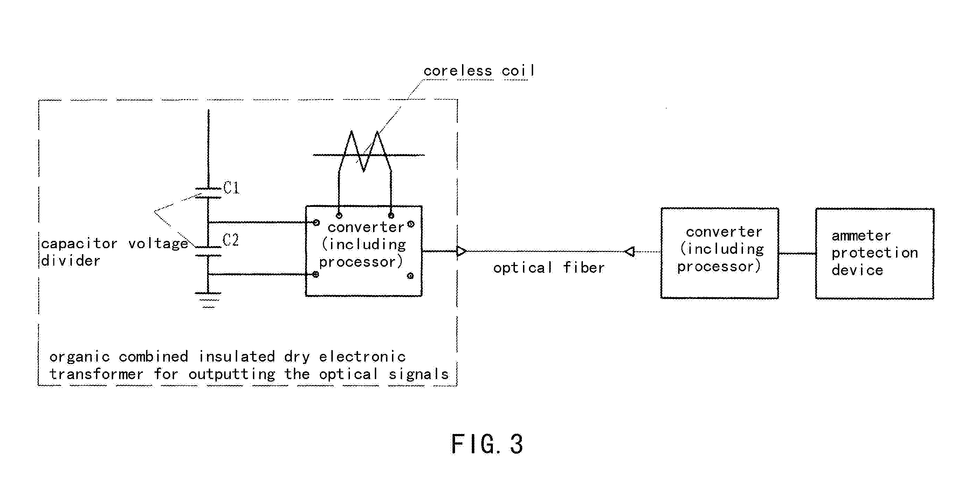

The above organic combined insulated dry electronic transformer for outputting an optical signal, provided according to the present invention, has such a structure in which the capacitor voltage-divider insulator of the organic insulated dry transformer functions as a main insulation, to bear all the whole high voltage. A coreless coil is wound around the outside of the tap of capacitance plate in the capacitor voltage-divider insulator to measure current; or utilizing the principle of capacitor voltage-divider, a low voltage signal is taken from the capacitance plate adjacent to the tap of capacitance plate in the capacitor voltage-divider insulator to measure voltage; then the received current signal or the voltage signal is inputted into the converter which converts an electric signal into an optical signal. The optical signal outputted from the converter can be transmitted to a remote control room via an optical fiber, and then converted into an electric signal again to drive an ammeter and a relay protection device, referring to the principle diagram shown in Fig. 3.

Compared with the conventional photoelectric mutual inductor, the organic combined insulated dry electronic transformer for outputting an optical signal of the present invention has the following advantages:
1. the capacitor voltage-divider insulator bears all the whole high voltage, and the coreless coil for measuring current, the voltage signal input terminals for measuring voltage and the converter are all located inside the grounded housing, thus various difficult problems caused by that sensors, converters, and power supplying part of the power supply are at high electric level in the conventional photoelectric transformer are solved. At the same time, the problem of supplying power to the converter is surely solved also, that is, the needed electric energy for the converter does not have to be achieved by sending laser to high voltage side via an optical fiber, then utilizing complex devices such as laser reception part, transformation part and power supply part and so on, which are operated in a high voltage environment. Instead, it can be directly achieved by providing AC or DC power supply to the converter from the ground. Meanwhile, because optical fiber transmission from high voltage to low voltage is replaced by optical fiber transmission from low voltage to low voltage, various difficult problems as to the high voltage insulation carrier needed for the optical fiber in the photoelectric transformer to withstand high voltage are solved;
2. the organic combined insulated dry electronic transformer is out of oil, out of porcelain, out of SF6, fire proof, explosion proof and pollution-flashover proof, with decreased amount of maintenance and increased safety and reliability;
3. the coreless coil is air core coil. It does not result in measurement errors due to the saturation of an iron core as in electromagnetic mutual inductors, therefore, the current, no matter large or small, can always been correctly detected, and only one coreless coil is needed for driving the meter or the relay protection device, so energy consummation caused by transmitting signals via the conducting wire is reduced in the meantime;
4. converting the voltage signal obtained from the capacitance plate adjacent to the tap of capacitance plate in the capacitor voltage-divider insulator into the optical signal for transmission can overcome the defect of overvoltage due to ferromagnetic resonance in the electrical power system caused by electromagnetic voltage transformers, and can also overcome the defect of ferromagnetic resonance in low voltage loops of capacitive voltage transformers;
5. the optical signal of low voltage is insensitive to electromagnetic interference in transmission, thereby measurement result of the ammeter is more accurate, and the action of driving the relay protection device is more reliable.

### BRIEF DESCRIPTION OF THE DRAWINGS

Fig. 1 is a partial sectional view, schematically showing an embodiment of the organic combined insulated dry electronic transformer for outputting an optical signal according to the present invention, in which the electric conductor is in I-shape ;
Fig. 2 is a schematic diagram of another embodiment of the organic combined insulated dry electronic transformer for outputting an optical signal according to the present invention, in which the electric conductor is in U-shape;
Fig. 3 is a functional diagram showing the organic combined insulated dry electronic transformer for outputting an optical signal according to the present invention drives an ammeter and a relay protection device after being connected to an optical fiber;
Fig. 4 shows an electric conductor structure for the embodiment shown in Fig. 1.

### DETAILED DESCRIPTION OF THE EMBODIMENTS

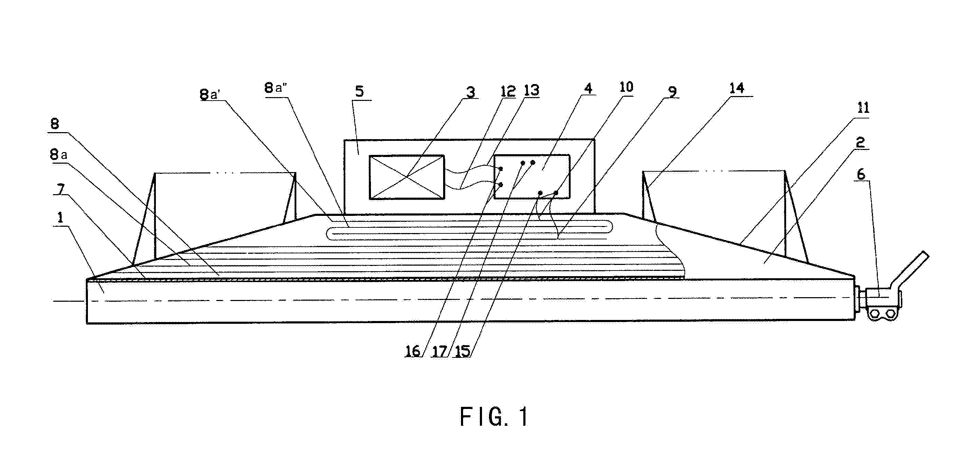

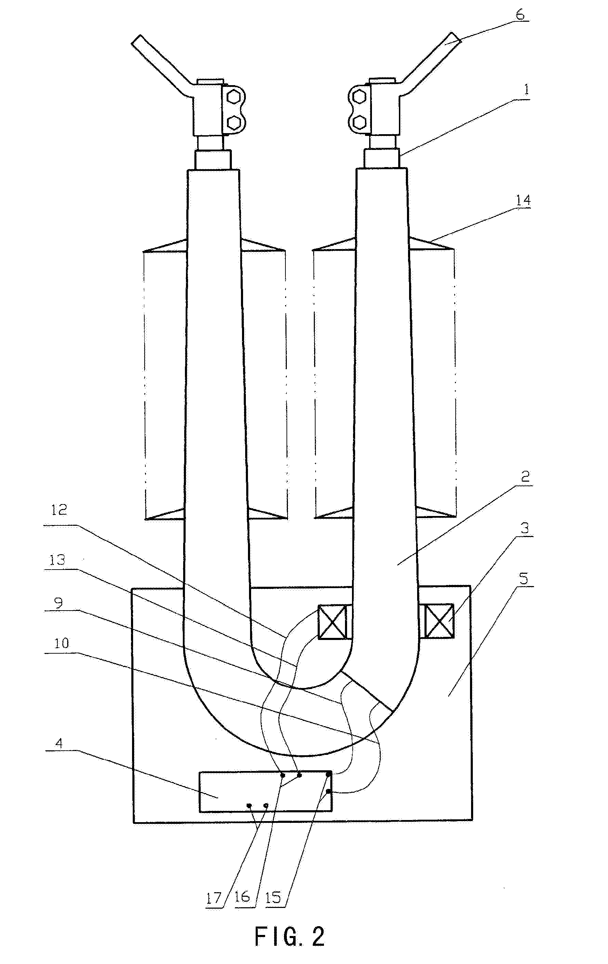

Referring to Figs. 1 and 2, an organic combined insulated dry electronic transformer for outputting an optical signal according to the present invention comprises an electric conductor 1 and a capacitor voltage-divider insulator 2 consisting of organic insulation layers 8 (such as polytetrafluoroethylene films) and cylindrical capacitance plates 8a alternatively wound around the electric conductor, wherein each cylindrical capacitance plate 8a is formed of conductive or semi-conductive material (such as aluminum foils). As shown in Fig. 1, the longer the radial distances from the organic insulation layer 8 and the capacitance plate 8a to the electric conductor 1 are, the shorter the axial lengths of the organic insulation layer 8 and the capacitance plate 8a are. An organic insulated outer jacket 11 is tightly wrapped around the outer surface of the capacitor voltage-divider insulator 2. The electric conductor 1 is provided with a wiring clip 6 (only one wiring clip is shown in Fig. 1) at each end thereof for conveniently connecting the mutual inductor to a line to be detected, such as a line of a transformer substation. A grounded housing 5 made of metal material is fitted over the outside of the organic insulated outer jacket 11 and located in a section defined by the tap of capacitance plate 8a'. The tap of capacitance plate 8a' is in a grounded state during operation. A coreless coil 3, fitted over the capacitor voltage-divider insulator 2, is disposed inside the grounded housing 5. The coreless coil 3 is formed by winding a metal wire around a non-magnetic material framework. A converter 4 is also disposed inside the grounded housing 5 for converting an electric signal, after processed, into an optical pulse signal. The converter 4, mounted inside a case made of metal material (not shown), comprises an electric signal processor and a photoelectric converter. The electric signal processor performs collecting, processing, and A/D converting of electric signals. The photoelectric converter converts an electric signal into an optical signal. The electric signal processor and the photoelectric converter are well-known, thus further detailed illustration is omitted here. Current signal input terminals 16, 16 and corresponding optical pulse signal output terminals 17, 17 of the converter 4 are disposed on the case. Two leads 12, 13 at ends of the coreless coil are connected respectively to the current signal input terminals 16, 16 of the converter 4. A silicon rubber umbrella 14 is adhered to or fitted over the outer jacket (11) of the capacitor voltage-divider insulator at the surface of its two ends beyond the grounded housing. Thus an organic insulated dry current transformer for outputting an optical signal is formed.

Referring to Figs. 1 and 2, voltage signal input terminals 15, 15 are also disposed on the case of the converter 4. A measurement lead 9 is led out from the capacitance plate 8a" adjacent to the tap of capacitance plate 8a', at the same time, a tap lead 10 is led out from the tap of capacitance plate 8a'. The measurement lead 9 and the tap lead 10 are respectively connected to the voltage signal input terminals 15, 15. Thus an organic combined insulated dry electronic transformer for outputting an optical signal is formed, with a current transformer and a voltage transformer integrated therein.

A person skilled in the art may understand easily, if the electric conductor 1 is configured as the I-shape structure shown in Fig. 1, it is possible to form an organic combined insulated dry electronic transformer for outputting an optical signal integrating functions of three kinds of electric apparatus, i.e. a wall bushing, a current transformer, and a voltage transformer, or an organic combined insulated dry electronic transformer for outputting an optical signal integrating functions of two kinds of electric apparatus, i.e. a wall bushing and a current transformer; and, if the electric conductor 1 is configured as the U-shape structure shown in Fig. 2, it is possible to form an organic combined insulated dry electronic transformer for outputting an optical signal integrating functions of two kinds of electric apparatus, i.e. a current transformer and a voltage transformer, or only the function of a current transformer, so as to reduce the occupied area, and reduce the manufacture cost of the equipment and the construction cost of the whole project.

Referring to Fig. 1, the electric conductor 1 may be formed by a metal conducting rod or a metal conducting pipe, with its outer surface attached by a semi-conductive transition layer 7 (such as a carburized ethylene propylene rubber semi-conductive adhesive tape), so as to further improve electric field and play function of stress relieving.

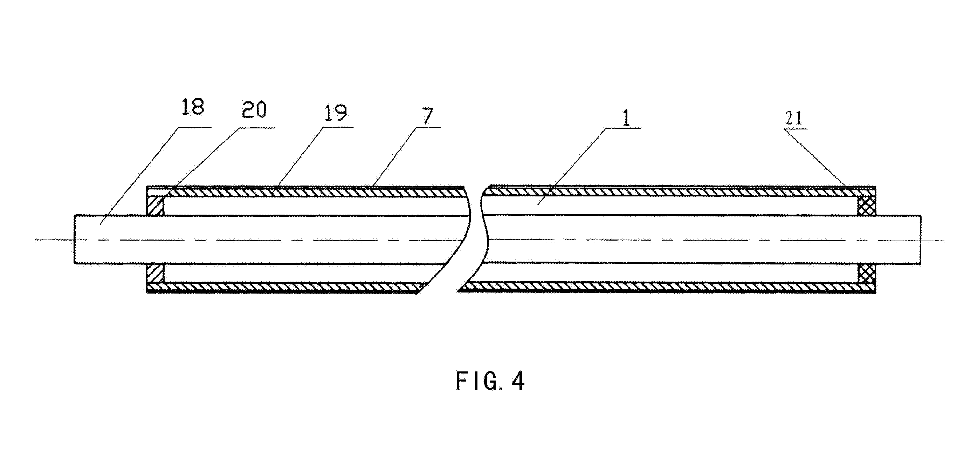

Referring to Fig. 4, as an alternative example, the electric conductor 1 may consists of a metal conducting rod or conducting wire 18, a non-magnetic metal pipe 19 (for example, a stainless steel pipe) fitted over the metal conducting rod or wire 18, and a semi-conductive transition layer 7 tightly attached to the outer surface of the non-magnetic metal pipe 19. One end of the metal conducting rod or conducting wire 18 may be electrically connected to the non-magnetic metal pipe 19 via a metal conducting ring 20, and the other end may be insulated supported within the magnetic metal pipe via a separating sheath 21 made of insulating material, as shown in Fig. 4. Since the electric conductor 1 also plays the role of the framework of the manufacture, the whole rigidity of the manufacture can be improved by utilizing the structure of the electric conductor shown in Fig. 4.

As shown in Fig. 1, the tap of capacitance plate 8a' and the adjacent capacitance plate 8a" of the capacitor voltage-divider insulator 2 are connected in parallel with another corresponding capacitance plate at inner side, respectively, so as to improve the capacitance of the low voltage capacitor C2 and decrease the divided voltage.

As an alternative example for the embodiment shown in Fig. 1, an dry voltage transformer for outputting an optical signal is formed without the coreless coil 3 disposed in the grounded housing 5. Such dry voltage transformer comprises an electric conductor 1; a capacitor voltage-divider insulator 2 consisting of organic insulation layers 8 and cylindrical capacitance plates 8a alternatively wound around the electric conductor, wherein each cylindrical capacitance plate 8a is made of conductive or semi-conductive material, and the longer the radial distances from the organic insulation layer 8 and the capacitance plate 8a to the electric conductor 1 are, the shorter the axial lengths of the organic insulation layer 8 and the capacitance plate 8a are; an organic insulated outer jacket 11 tightly wrapped around the outer surface of the capacitor voltage-divider insulator 2; and wiring clips 6 each disposed respectively at each end of the electric conductor 1; a grounded housing 5 fitted over the outside of the organic insulated outer jacket 11 and located within a section defined by the tap of capacitance plate 8a'; a converter 4, mounted inside a case made of metal material (not shown), disposed inside the grounded housing 5 for converting an electric signal into an optical signal; voltage signal input terminals 15, 15 and corresponding optical signal output terminals 17, 17 disposed on the case; a measurement lead 9 led out from the capacitance plate 8a" adjacent to the tap of capacitance plate 8a'; a tap lead 10 led out from the tap of capacitance plate 8a', and wherein the measurement lead 9 and the tap lead 10 are respectively connected to the voltage signal input terminals 15, 15 of the converter 4, and silicon rubber umbrellas 14 are disposed on the outer jacket 11 of the capacitor voltage-divider insulator at the surface of its two ends beyond the grounded housing.

Some specific manufacture examples of the organic combined insulated dry electronic transformer for outputting an optical signal according to the present invention are provided below:

### First Example

Referring to Fig. 1, the organic combined insulated dry electronic transformer for outputting an optical signal, with a rated voltage of 110kV, a rated current of 1200A, and a structure of an I-shape conducting rod, can be utilized as a wall bushing, for current measurement, voltage measurement and relay protection simultaneously. The steps for manufacturing the transformer are as follows:
a. selecting a copper bar having a diameter of 30mm as the conducting rod 1;
b. selecting the length of the grounded housing as about 1m, and the length of the conducting rod 1 as 3.5m since the rated voltage of 110kV requires an air gap of 1m;
c. winding a layer of carburized ethylene-propylene rubber semi-conductive adhesive tape 7 around the conducting rod 1;
d. winding initially the first layer of polytetrafluoroethylene insulation tape 8 coated with silicone oil around the outside of the semi-conductive adhesive tape 7; then disposing tightly the first layer of capacitance plate 8a by using an aluminum foil having a length of 3m; winding the insulation tape on the outside of the capacitance plate 8a again and repeating the above process until the 17th layer of capacitance plate and the 18th layer of capacitance plate are obtained, with aluminum foil conductive pieces for both the 17th layer of capacitance plate and the 18th of layer capacitance plate reserved; while forming the 19th layer of capacitance plate, connecting the 17th layer of capacitance plate with the 19th layer of capacitance plate 8a" in parallel via the reserved aluminum foil conductive piece, meanwhile, pressing a metal wire, which has a diameter of 2.5mm² and comprises an insulation skin, tightly onto the 19th layer of capacitance plate 8a" by using a spring hoop, wherein each layer of insulation tape 8 has a thickness of about 1.5mm, the length of each layer of capacitance plate decreases by 50 mm one after another, and the metal wire is used as the measurement lead 9;
e. keep on winding the 20th layer (i.e. the last layer) of capacitance plate, and connecting the 18th layer of capacitance plate with the 20th layer of capacitance plate 8a' in parallel in the same way via the reserved aluminum foil conductive piece, meanwhile, pressing a metal wire having a diameter of 2.5mm² and comprising an insulation skin tightly onto the 20th layer of capacitance plate by using a spring hoop, wherein the metal wire is used as the tap lead 10;
f. shrinking a heat shrinkable tube 11 on the whole capacitor voltage-divider insulator 2, and exposing the measurement lead 9 and the tap lead 10 out of the heat shrinkable tube in the middle section of the capacitor voltage-divider insulator;
g. mounting the coreless coil 3 and the converter 4 inside a grounded housing 5, with the leads 12, 13 at two ends of the coreless coil connected to the current input terminals 16, 16 of the converter 4;
h. fitting the grounded housing 5 over the outside of the heat shrinkable tube 11 of the capacitor voltage-divider insulator 2 (the portion defined by the tap of capacitance plate 8a'), and fixing the grounded housing 5 to the capacitor voltage-divider insulator 2;
i. connecting the measurement lead 9 and the tap lead 10 with the voltage input terminals 15, 15 of the converter 4;
j. integral silicon rubber umbrellas are disposed on the surface of the two ends, beyond the grounded housing 5, of the outer jacket 11 of the capacitor voltage-divider insulator.

### Second Example:

Referring to Fig. 2, the organic combined insulated dry electronic transformer for outputting an optical signal, with a rated voltage of 110kV, a rated current of 1200A, and a structure of an U-shape conducting rod, can be utilized for current measurement, voltage measurement and relay protection simultaneously. The steps for manufacturing the transformer are as follows:
a. selecting a copper bar having a diameter of 30mm as the conducting rod 1, and bending it into U-shape;
b. selecting the length of the U-shape conducting rod in the grounded housing as about 1.5m, and the length of the conducting rod 1 as 4m since the rated voltage of 110kV requires an air gap of 1m;
c. repeating the steps of c-g in the first example;
d. fitting the grounded housing 5 over the outside of the heat shrinkable tube 11 of the capacitor voltage-divider insulator 2 (the portion defined by the tap of capacitance plate 8a'), and fixing the grounded housing 5 to the capacitor voltage-divider insulator 2;
e. repeating the steps of i and j in the first example.

### Third Example:

Referring to Figs. 1 and 2, the organic combined insulated dry voltage transformer for outputting an optical signal, with a rated voltage of 110kV, a rated current of 1200A, and a structure of an I-shape or U-shape conducting rod, can be utilized merely for voltage measurement and relay protection. The steps for manufacturing the transformer are as follows:
a. selecting a copper bar having a diameter of 30mm as the conducting rod 1, and making it into I-shape or U-shape;
b. selecting the length of the conducting rod 1 as 4m if U-shape conducting rod 1 is used, since the rated voltage of 110kV requires an air gap of 1m;
c. repeating the steps of c-f in the first example;
d. mounting the converter 4 inside the grounded housing 5;
h. fitting the grounded housing 5 over (in case of I-shape conducting rod) or mounting the grounded housing 5 on (in case of U-shape conducting rod) the outside of the heat shrinkable tube 11 of the capacitor voltage-divider insulator 2 (the portion defined by the tap of capacitance plate 8a'), and fixing the grounded housing 5 to the capacitor voltage-divider insulator 2;
i. connecting the measurement lead 9 and the tap lead 10 with the voltage input terminals 15, 15 of the converter 4;
j. integral silicon rubber umbrellas are disposed on the surface of the two ends, beyond the grounded housing 5, of the outer jacket 11 of the capacitor voltage-divider insulator.

### Fourth Example:

Referring to Figs. 1 and 2, the organic combined insulated dry current transformer for outputting an optical signal, with a rated voltage of 110kV, a rated current of 1200A, and a structure of an I-shape or U-shape conducting rod, can be utilized merely for current measurement and relay protection. The steps for manufacturing the transformer are as follows:
a. selecting a copper bar having a diameter of 30mm as the conducting rod 1, and making it into I-shape or U-shape;
b. selecting the length of the conducting rod 1 as 4m if U-shape conducting rod 1 is used, since the rated voltage of 110kV requires an air gap of 1m;
c. repeating the step of c in the first example;
d. winding initially the first layer of insulation tape 8 around the outside of the semi-conductive adhesive tape 7; then disposing tightly the first layer of capacitance plate 8a by using an aluminum foil having a length of 3m; winding a insulation tape on the outside of the capacitance plate 8a again and repeating the above process until the 20th layer of capacitance plate is obtained; pressing a metal wire, which has a diameter of 2.5mm² and comprises an insulation skin, tightly onto the 20th layer of capacitance plate 8a' by using a spring hoop, wherein each layer of insulation tape 8 has a thickness of about 1.5mm, the length of each layer of capacitance plate decreases by 50 mm one after another, and the metal wire is used as the tap lead 10;
e. shrinking a heat shrinkable tube 11 on the whole capacitor voltage-divider insulator 2, and exposing the tap lead 10 out of the heat shrinkable tube in the middle section of the capacitor voltage-divider insulator;
f. repeating the step of g in the first example;
g. fitting the grounded housing 5 over (in case of I-shape conducting rod) or mounting the grounded housing 5 on (in case of U-shape conducting rod) the outside of the heat shrinkable tube 11 of the capacitor voltage-divider insulator 2 (the portion defined by the tap of capacitance plate 8a'), and fixing the grounded housing 5 to the capacitor voltage-divider insulator 2;
h. integral silicon rubber umbrellas are disposed on the surface of the two ends, beyond the grounded housing 5, of the outer jacket 11 of the capacitor voltage-divider insulator.

The above embodiments and the specific examples are given only for illustrating and understanding the invention, they are not intended to limit the present invention. The scope of the present invention should be defined by the claims.

## Claims

1. An organic combined insulated dry electronic transformer for outputting an optical signal, comprising: an electric conductor (1); a capacitor voltage-divider insulator (2) consisting of organic insulation layers (8) and cylindrical capacitance plates (8a) alternatively wound around the electric conductor, wherein each cylindrical capacitance plate (8a) is made of conductive or semi-conductive material, and the longer the radial distance from the capacitance plate (8a) to the electric conductor (1) is, the shorter the axial length of the capacitance plate (8a) is; an organic insulated outer jacket (11) tightly wrapped around the outer surface of the capacitor voltage-divider insulator (2); and wiring clips (6) each disposed respectively at each end of the electric conductor (1), **characterized in** further comprising:
a grounded housing (5) fitted over the outside of the organic insulated outer jacket (11) and located within a section defined by the tap of capacitance plate (8a');
a coreless coil (3) and a converter (4) disposed inside the grounded housing (5), wherein the coreless coil (3) is fitted over the capacitor voltage-divider insulator (2) and the converter (4) is used for converting an electric signal, after processed, into an optical signal;
electric signal input terminals (16, 16) and corresponding optical signal output terminals (17, 17) disposed on the converter, wherein the electric signal input terminals (16, 16) on the converter (4) are respectively connected to leads (12, 13) at both ends of the coreless coil (3), and
silicon rubber umbrellas (14) disposed on the outer jacket (11) of the capacitor voltage-divider insulator at the surface of its two ends beyond the grounded housing.

2. The organic combined insulated dry electronic transformer according to claim 1, **characterized in that**:
the longer the radial distance from the organic insulation layer (8) to the electric conductor (1) is, the shorter the axial length of the organic insulation layer (8) is.

3. The organic combined insulated dry electronic transformer according to claim 1, **characterized in** further comprising:
a measurement lead (9) led out from the capacitance plate (8a") adjacent to the tap of capacitance plate (8a');
a tap lead (10) led out from the tap of capacitance plate (8a'), and
wherein the measurement lead (9) and the tap lead (10) are respectively connected to the electric signal input terminals (15, 15).

4. The organic combined insulated dry electronic transformer according to claim 1 or 3, **characterized in that**:
the coreless coil (3) is formed by winding an metal wire around a non-magnetic material framework.

5. The organic combined insulated dry electronic transformer according to claim 1 or 3, **characterized in that**:
the converter (4) is mounted inside a case made of metal material, the converter (4) comprises an electric signal processor and an photoelectric converter which converts an electric signal to an optical signal, and the electric signal input terminals (15, 15, 16, 16) and the corresponding optical signal output terminals (17, 17) are disposed on the case.

6. The organic combined insulated dry electronic transformer according to claim 1 or 3, **characterized in** further comprising:
a semi-conductive transition layer (7) attached to the outer surface of the electric conductor (1).

7. The organic combined insulated dry electronic transformer according to claim 3, **characterized in that**:
at least one of the tap of capacitance plate (8a') and the adjacent capacitance plate (8a") are connected in parallel with at least one corresponding capacitance plate at inner side.

8. The organic combined insulated dry electronic transformer according to claim 1 or 3, **characterized in that**:
the electric conductor (1) consists of a metal conducting rod or conducting wire (18), a non-magnetic metal pipe (19) fitted over the metal conducting rod or wire (18), and a semi-conductive transition layer (7) tightly attached to the outer surface of the non-magnetic metal pipe (19); the electric conductor (1) is in I-shape or U-shape; the metal conducting rod or conducting wire (18) has one end electrically connected to the non-magnetic metal pipe (19) via a metal conducting ring (20), and the other end insulated supported within the non-magnetic metal pipe (19) via a separating sheath (21) made of insulating material.

9. The organic combined insulated dry electronic transformer according to claim 1, **characterized in that**:
the silicon rubber umbrellas (11) are adhered to or fitted over the surface of the organic insulated outer jacket (11).

10. An organic combined insulated dry electronic transformer for outputting an optical signal, comprising: an electric conductor (1); a capacitor voltage-divider insulator (2) consisting of organic insulation layers (8) and cylindrical capacitance plates (8a) alternatively wound around the electric conductor, wherein each cylindrical capacitance plate (8a) is made of conductive or semi-conductive material, and the longer the radial distances from the organic insulation layer (8) and the capacitance plate (8a) to the electric conductor (1) are, the shorter the axial lengths of the organic- insulation layer (8) and the capacitance plate (8a) are; an organic insulated outer jacket (11) tightly wrapped around the outer surface of the capacitor voltage-divider insulator (2); and wiring clips (6) each disposed respectively at each end of the electric conductor (1), **characterized in** further comprising:
a grounded housing (5) fitted over the outside of the organic insulated outer jacket (11) and located within a section defined by the tap of capacitance plate (8a');
a converter (4) disposed inside the grounded housing (5) for converting an electric signal into an optical signal;
electric signal input terminals (15, 15) and corresponding optical signal output terminals (17, 17) are disposed on the converter (4);
a measurement lead (9) led out from the capacitance plate (8a") adjacent to the tap of capacitance plate (8a');
a tap lead (10) led out from the tap of capacitance plate (8a'), wherein the measurement lead (9) and the tap lead (10) are respectively connected to the electric signal input terminals (15, 15) of the converter (4), and
silicon rubber umbrellas (14) disposed on the outer jacket (11) of the capacitor voltage-divider insulator at the surface of its two ends beyond the grounded housing.
